# EUROPEAN PATENT APPLICATION

(11) **EP 3 965 147 A1**
(43) Date of publication of application: **09.03.2022**
(21) Application number: 20194347.9
(22) Date of filing: 03.09.2020
(51) Int. Cl.: H01L 23/045, H01S 5/022

(54) **HEADER FOR AN ELECTRONIC OR OPTO-ELECTRONIC COMPONENT AND PROCESS FOR MANUFACTURING OF SUCH**

(71) Applicant: SCHOTT AG, 55122 Mainz (DE)
(72) Inventor: DROEGEMUELLER, Karsten, 82223 Eichenau (DE); AOWUDOMSUK, Artit, Donmueang Bankok 10210 (TH); WAI LI, Ong, 81100 Johor Bahru (MY); TAN, Jian Dean, Singapore 640409 (SG); SOON, Amy, Singapore 82880 (SG); KRAUSE, Andreas, 84186 Vilsheim (DE)
(74) Representative: Blumbach · Zinngrebe Patentanwälte PartG mbB

(57) **Abstract**

A header (1) for an electronic component, comprising a base (3) with at least one feedthrough (5), the feedthrough (5) comprising a feedthrough pin (6) extending through the base (3) and being electrically insulated from the base (3), and at least one pedestal (7, 7a) connected to the base and comprising a submount (9) connected to the pedestal (7), wherein the pedestal (7, 7a) is joined to the base (3) via a pedestal substance-to-substance bond (24).

## Description

### Field of invention

The invention relates in general to the packaging of electronic components. In particular, the invention relates to the design of a header, preferably a transistor outline (TO) header for mounting an electronic or opto-electronic device. The invention is particularly suitable for laser diodes as electronic or optoelectronic devices. However, the invention relates to electronic packaging for any electronic component in which a submount for being electrically connected to a feedthrough pin is arranged on and attached to a pedestal.

For example, for some opto-electronic applications, the wavelengths of the beam emitted by the laser chip needs to be controlled precisely, as the wavelength of the laser is temperature dependent. Therefore, the temperature of the laser should be stabilized within a narrow temperature range. To this end, it is known to use a thermo-electric cooler (TEC) that may be included within the housing for the laser diode, such as a transistor outline (TO) package. TECs may be used in tandem with directly modulated Lasers (DML) for midrange distances. DML offer the advantage of a lower cost when compared to EML. However, many laser driver ICs are driving the DML with differential signals. In this case, the header needs two RF signal lines. These two signal lines should preferably have a characteristic impedance Z₀ = 25 Ohm to avoid signal degradation from reflections others then from the DML.

Further, the TEC has a hot and a cold side. The hot side is connected to the header for heat dissipation. The DML is mounted on the cold side. The cold side should be thermally isolated from the hot side to prevent thermal feedback and a self-heating effect. On the other hand, two RF lines must be connected to the DML. One well known concept is to use two separate RF lines. Each RF line comprises a small printed wire board (pedestal submount or submount) to bring the signal to the DML inside the header. Each pedestal submount may be mounted on a separate pedestal. Typically, the pedestals and the eyelet or base of the header are made in one stamping process as one piece.

However, the present invention is not restricted to headers for packaging DML laser chips, but relates in general to packaging of electronic components.

The eyelet or base of the header comprises several openings for accommodating pins, for example, to electrically connect the submount connected to a respective pedestal. That is, each pedestal corresponds to a respective opening.

A drawback of state-of the art headers is that the position of the pedestal with respect to the respective opening is fixed. However, the pin position in the opening cannot be controlled precisely, varying between a maximum position and a minimum position. In case the pin is located in the maximum position, the distance between the pin and the pedestal is large. This allows to arrange the submount on the pedestal. However, as a drawback, such a large distance between pin and submount will result in a high insertion loss. However, the distance between opening and pedestal may not be minimized, as this might result in too small a distance between the pedestal and the pin to arrange the submount in between the both in case the pin is in the minimum position.

Therefore, there is a need for headers for mounting an electronic or optoelectronic device with a low insertion loss as well as for a process for manufacturing such a header.

### Object of invention

The object of the present invention is to provide a header, in particular, a TO header, for mounting an electronic or optoelectronic component that provides for a low insertion loss. A further aspect of the present invention relates to a process for manufacturing such a header.

### Summary of invention

The object of the invention is achieved by the subject-matter of the independent claims. Preferred embodiments and further refinements of the invention are specified by the subject matter of the dependent claims, the description, and the drawings.

The invention therefore relates to a header for an electronic component, in particular, an optoelectronic component, such as a laser chip. The header comprises a base with at least one feedthrough. The feedthrough comprises a feedthrough pin (or simply pin) extending through the base. The pin is electrically isolated from the base. Further, the header comprises at least one pedestal that is connected to the base. The pedestal comprises a submount connected to the pedestal. The pedestal is joined to the base via a substance-to-substance bond, for example, via a braze joint or by using a conductive adhesive.

Such a header offers several advantages.

First of all, the base and the at least one pedestal of the header are formed as separate components. This reduces the complexity of the base forming process and allows for a quick and cheap production of the header base.

Further, if the header base and the pedestal or pedestals are formed as separate parts, the header base may also be further processed without damages to the pedestals . For example, the header base already comprising at least one feedthrough may be processed to have a more precise feedthrough impedance control. For example, due to capillary action, the surface of the sealing glass will not be flat, which influences impedance. A more reliable performance of the feedthrough may be achieved by grinding the sealing glass in order to obtain a flat glass surface. Preferably, the surface of the header base and the sealing glass surface may even be ground in the same processes, thereby obtaining a flat glass surface on the same level with the surface of the header base, that is, the glass surface and the header base surface are in-plane, which results in an almost 100% control of the impedance along the feedthrough length.

Furthermore, the at least one pedestal is formed in a separate manufacturing process, for example, by stamping, metal drawing or extrusion. Because of this, the at least one pedestal may be formed with a special, even complex, geometry, for example, with an edge, such as a chamfered edge (or chamfer edge) or a rounded edge (blend edge) and/or a back taper and/or a complex shape of the pedestal profile. For example, as pedestal and base of the header are formed as separate parts, it may be contemplated to use a pedestal with a complex shape, as will be explained in detail further below.

The separate manufacturing of header base and pedestal offers the further advantage that header base and pedestal or, in the case of more than one pedestal, pedestals may be different. For example, the header base may be made of a material selected for easy glass-to-metal-sealing, whereas the pedestal may be made of a material with high thermal conductivity, for example.

Furthermore, in a separate manufacture process, the pedestal or pedestals may be shaped in various types, offering several advantages. It is possible that in case of more than one pedestal, all pedestals have the same shape; however, it is also possible that that one header comprises pedestals with different shapes.

Furthermore, the pedestal and the base are joined in a separate joining process, thereby allowing to optimize or at least control the distance between the submount and the pin. This results in a smaller insertion loss of the packaged electronic, in particular opto-electronic, component, as the offset between the submount surface and the pin may be set in a narrow range. Advantageously, joining is effected via a substance-to-substance bond (pedestal substance-to-substance bond) so that the pedestal if fixedly attached to the base. In the scope of the present invention, a substance-to-substance bond is understood to refer to a joining process of different materials or between different parts by forming an adhesive bond between adjoining materials or adjoining parts. Such an adhesive bond between materials or between different parts may be formed by using an adhesive, and/or by at least partially melting the parts or materials to be joined. In the present case, as the present invention relates to a header used in electronic packaging, adhesives used for joining metals are particular suitable. For example, adhesives suited for forming conductive bonds of conductive adhesives may be particularly suited, such as a nano sintered silver and conductive adhesive. In particular, according to the present disclosure, and without being limited to the pedestal substance-to-substance bind, the substance- to-substance bond may be formed as a braze joint, that is, by joining metal parts using a braze material. In that sense, braze materials as well as solders may be understood to be an adhesive in the sense of the present disclosure. In contrast to soldering, brazing usually is effected at a higher temperature. Further, brazing usually requires closely fitted parts that are to be joined, which allows the melted braze to be drawn into the gap between the metal parts to be joined by capillary action. In this way, only a very small amount of excess brazing material may be produced, resulting in only a small brazing bulge. This further allows for a very tight and close connection with minimal offset between adjoining parts, that is, the base (or rather, the surface of the base) and the submount (or rather, a side face or edge of the submount).

According to an embodiment, the offset between the pin and the surface of the submount (pin offset) is at most 0.2 mm, in order to provide a good signal transmission of the electronic component of the header. According to a further embodiment, the pin offset is at least 0.05 mm, in order to avoid damage to the component side of the submount during assembly.

According to an embodiment, the submount is joined to the pedestal via a further substance-to-substance bond (submount substance-to-substance bond). As stated above, such a substance-to-substance bond offers several advantages, such as a tight bond between adjoining parts, preferably with only a minimal offset between adjoining parts. Forming that substance-to-substance bond, for example by brazing the submount to the pedestal, may be effected both prior to or after fixedly attaching the pedestal to the base by forming a further substance-to-substance bond, for example, by brazing the pedestal to the base. Either way allows for a very tight, close connecting between adjacent parts of the header.

According to an embodiment, the offset between the submount edge and the surface of the base (submount offset) is at most 0.1 mm.

In a particularly preferred embodiment, therefore, the offset between the base surface and the submount edge may even be 0.

In other words, the header according to embodiments of the present invention allows for optimized offsets, which in turn results in less insertion loss of the electronic component and, therefore, a greater signal bandwidth.

In the context of the present application, the following definitions apply:
The term "electronic component" encompasses, i.a., opto-electronic components. Suitable electronic components in electronic or, in particular, opto-electronic applications may be, but are not limited to, laser diodes (LD), such as electro-absorption modulated laser diodes (EML), distributed feedback laser (DFB), Fabryperot laser (FP), optical modulators, photodiodes (PD) and other electronic components used for optical communication.
A submount - that may also be called "pedestal submount" in the scope of the present invention - typically comprises an insulating material as carrier. Suitable insulating materials comprise, but are not limited to, ceramics such as alumina Al₂O₃ or aluminum nitride AlN, or glass. The thickness of the submount preferably is between 0.1 mm and 0.5 mm. The length of the submount may be adjusted in order to match, for example, the focal length of a lens that couples light from a DML into a glass fibre in case the electronic component comprised by the header is a DML. In that case, a typical submount length may be 1.0 mm or 2.5 mm. Further, the length of the submount may range generally from 0.5 mm to 1 mm, with a typical width being 0.77 mm. The surface of the submount facing away from the pedestal (the "top side") has metal patterns applied to it and may also be denoted "component side" or "component face" in the scope of the present application. Further, the side of the submount facing the pedestal may also be denoted "carrier side" (or "carrier face") or "mounting side/face".

### Description of figures

The invention will now be further explained with reference to the following figures. In the figures, like reference numerals indicate like or corresponding elements. Further, all drawings relating to headers and parts of headers are drawn schematically and not to scale. The figures show:
Fig. 1 a perspective view of a header according to an embodiment,
Fig. 2 a sectional partial views of a header according to an embodiment,
Fig. 3 an exemplary diagram of the insertion loss as function of component offsets,
Fig. 4 an exemplary diagram of the return loss as function of component offsets,
Fig. 5 a further sectional partial view of a header according to an embodiment,
Fig. 6 the phase diagram of the binary system Au-Ge, and
Fig. 7 and 8 further partial sectional views of headers according to embodiments.

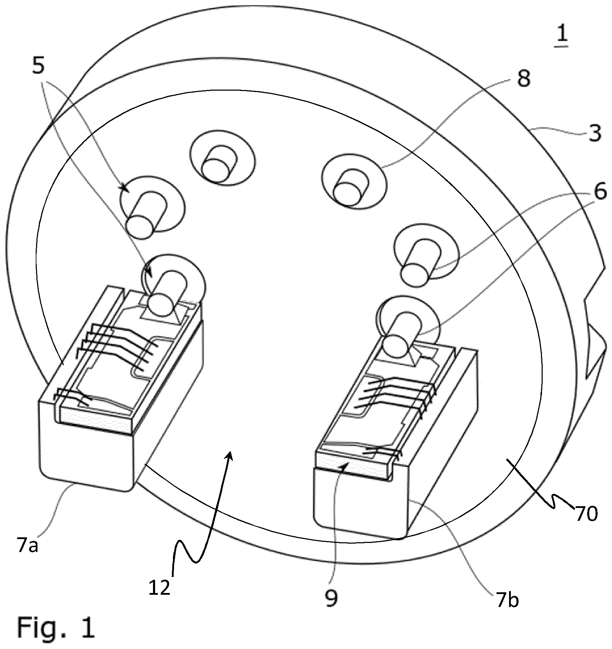

Fig. 1 is a perspective side view of a header 1 according to an embodiment.

The header 1 as shown in Fig. 1 comprises a base 3 with two or more electrical feedthroughs 5. The feedthroughs 5 serve to transmit electrical signals in or out of the header 1. Each feedthrough 5 comprises a feedthrough pin 6 that extends through the base 3 and is electrically isolated from it. For this purpose, the base 3 comprises eyelets or openings 8 filled with an insulating material, preferably glass, in which the feedthrough pin 6 is fixed. Two pedestals 7a, 7b are connected to and protrude from the base 3. Generally, without being restricted to the embodiment as depicted in fig. 1, the header 1 comprises at least one pedestal 7. However, it may be preferred to provide a header 1 with at least two pedestals 7a, 7b, for example for headers comprising laser chips, especially DML, as in many cases, laser driver IC are driving the DML with differential signals, meaning that header 1 needs two signal lines or single ended signal with one forward line and one return line. Without restriction to the specific example as shown, in a preferred embodiment, the pedestals 7 7a, 7b are arranged in a distance with a gap 12 in between. Gap 12 serves to accommodate further elements, in particular an assembly for carrying the electronic device, such as a laser chip. On each of the pedestals 7a, 7b, a submount 9 is attached. Further, an exemplary bonding area 70 of base 3 is depicted. Generally, a bonding area is understood as referring to a portion of a component or part indented or at least suited for being joined to further components or parts at least in a sub-portion thereof. For example, the surface of a component, that is, base 3 of header 1 in the case of header 1 as shown in fig. 1, may be processed in a way to enable or facilitate joining processes. For example, it is known to coat or plate surfaces of components to be joined at least partially with metals such as nickel and/or gold. Nickel is known to improve the solderability of, for example, copper, whereas a thin gold layer may be employed in order to avoid the oxidation of the nickel layer. For the header as depicted in fig. 1, for example, it is understood that at least in bonding area 70, in which further components may be joined to header base 3, the surface 58 of base 3 is Au-plated (or gold-plated) at least partially. Of course, it is generally possible that the whole of the surface 58 of base 3 or even the whole base 3 is gold-plated. Further, the base may be nickeled at least partially. In this case, preferably, the nickel layer is covered by a gold layer at least partially, preferably totally, in order to avoid oxidation of the nickel layer.

At least one of pedestals 7a, 7b, preferably both, or in case header 1 comprises more than the exemplarily depicted pedestals 7a, 7b, all pedestals 7 of header 1 are joined to base 3 via a substance-to-substance bond 24 (not shown in fig.1). Substance-to-substance bond 24, formed between a pedestal 7, 7a, 7b and base 3 may also be called pedestal substance-to-substance bond.

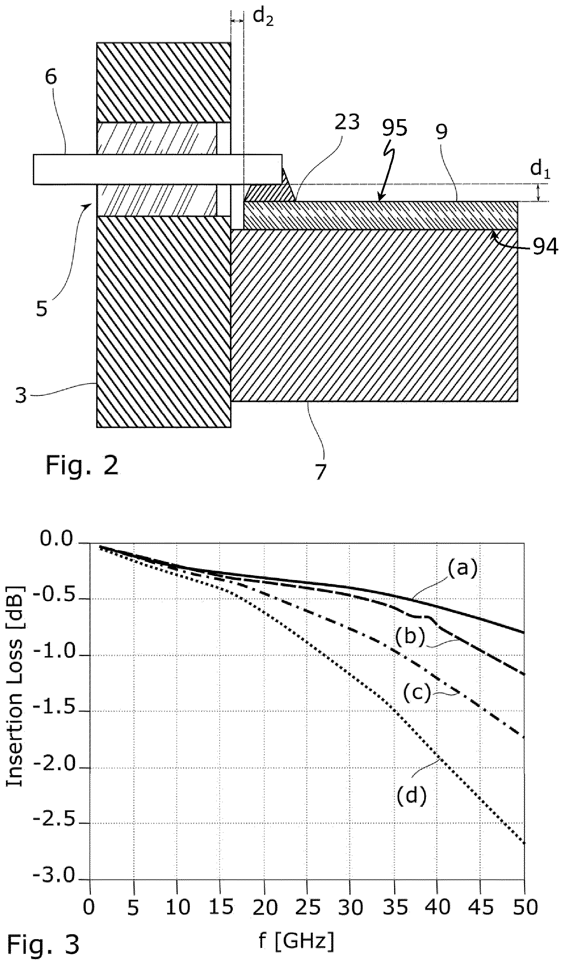

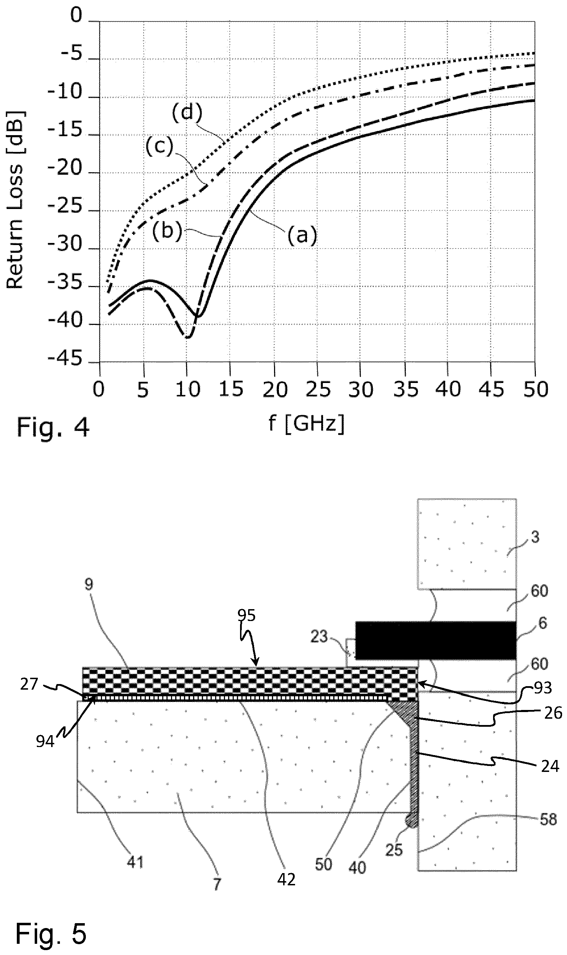

A substance-to-substance bond is understood here to refer to a bond (or a joint) between parts, especially metal parts, that are to be joined in a tight, close connection, preferably enabling a precise control of offsets between adjoining parts (or components), such as pedestal 7 and base 3 or submount 9 and pin 6. This may in a particularly preferred embodiment be achieved by brazing, that is, according to this preferred embodiment, substance to substance bond 24 may be formed as a braze joint or braze bond. However, such a bond may also be formed by using a conductive adhesive. For explanation, reference is now made to fig. 2, a sectional partial view of header 1 according to an embodiment, comprising base 3, feedthrough 5 with pin 6 and pedestal 7 comprising submount 9 with submount component face 95 (or upper side or upper surface) and submount carrier face 94 (or back side or bottom side of face). Here, submount 9 is electrically connected to pin 6 via a solder joint 23. In the exemplary header as depicted in fig. 2, pin 6 is centered in opening 8 of feedthrough 5, however, in general, without being restricted to the exemplary header shown in fig. 2, the position of a pin 6 in an opening 8 will vary due to production tolerances. Therefore, the offset (or distance) d₁ between the surface of submount 9 and pin 6 usually will vary. In case the position of pedestal 7 is fixed within the base - which will be the case in state of the art headers made in a standard stamping process - off-centering of pin 6 within opening 8 resulting in either a very large or a very small distance between pin 6 and submount upper face or component face 95 may not be compensated for. However, if pedestal 7 is joined to base 3 in a separate bonding process via substance-to-substance bond 27 (not shown here), offset d₁ (pin offset) may be set in a narrow range. The same applies to offset d₂ (submount offset) between the side face or edge 93 (not indicated here) of submount 9 and base 3. As a bonding process, preferably a bonding process using an adhesive material, particularly preferably a brazing process, is used to join pedestal 7 and base 3 that are closely fitting (or matching) parts, the adhesive material, for example, a melted braze is drawn into a very small gap between these parts by capillary action. In this way, only a very small amount of excess bonding or adhesive material, such as brazing material, may be produced, resulting in only small material bulge 25 (for example, a brazing bulge) (as shown in fig. 5). This further allows for a very tight and close connection with minimal or at least tightly controlled offset between adjoining parts.

The technical advantages are shown in exemplary diagrams in fig. 3 (relating to the insertion loss) and 4 (relating to the return loss), showing data obtained in a simulation for a given header design of an exemplary header according to an embodiment. For calculating the insertion and return losses, the overall header design was kept, with only pin and submount offset values varying between 0 mm and 0.1 mm for submount offset d₂ and between 0.05 mm and 0.2 mm for pin offset d₁. In both figures, a) denotes values obtained for a submount offset (d₂) of 0 mm and a pin offset (di) of 0.05 mm, b) denotes values obtained for d₂ = 0 mm and d₁ = 0.2 mm, c) for d₂ = 0.1 mm and d₁ = 0.05 mm and d) for d₂ = 0.1 mm and d₁ = 0.2 mm.

The bandwidth of a signal is defined as the frequency value at an insertion loss of 1 dB. As can be seen in fig. 3, the bandwidth may vary between 27 GHz in case d) for high offsets, whereas in case of small offsets (or even zero offset) as in case a), the bandwidth is more than 50 GHz, meaning that in case of large offsets, the bandwidth may be cut in half or even be lower for offsets larger than those used for calculation in fig. 3 and 4.

The return loss is shown in fig. 4. The return loss bandwidth is usually defined at a return loss of -15 dB, wherein a high return loss is favorable. The return loss bandwidth may vary for the exemplary header considered here between 15 GHz and 30 GHz, depending on the offset values, and is higher (and therefore, preferred) for low offsets (case a)).

In order to achieve high signal transmission, therefore, offset values should be tightly controlled.

According to an embodiment, the offset between submount 9 and the surface 58 of base 3 (submount offset, d₂) is of at most 0.1 mm and may, in a particularly preferred embodiment, even be 0 mm.

According to a further embodiment, the offset between pin 6 and the component face 95 of submount 9 (pin offset, d₁) is at most 0.2 mm. However, even if minimizing pin offset d₁ might be favorable from a signal bandwidth point of view, as submount mounting processes should be taken into account, the minimum value of the pin offset is, according to a further preferred embodiment, at least 0.05 mm. This allows to first join pedestal 7 to base 3 in a first bonding process, such as a brazing process, and subsequently joining submount 9 to pedestal 7 in a further, second bonding process, for example, a brazing process, without risking damage to submount 9, that is, a metal pattern or metal patterns applied to component side 95 of submount 9.

Fig. 5 depicts a further sectional partial view of an exemplary header 1 according to an embodiment. In the example shown in fig. 5, pedestal 7 is joined to base 3 (or the surface 58 of base 3) via substance-to-substance bond 24 (for example, a braze joint or braze bond), located between the surface 58 of base 3 and mounting face 40 of pedestal 7. Further, submount 9 is joined to pedestal 7 via substance-to-substance bond 27 (for example, a braze joint or braze bond), located between upper surface 42 of pedestal 7 and carrier face 94 of submount 9. Further, side face 93 of submount 9 has been indicated. Here, upper surface 42 relates to that side of the pedestal facing pin 6 and may also be denoted as pin face 42 of pedestal 7, and the bottom or back side of submount 9 is understood as referring to carrier side or carrier face 94 of submount 9 (in contrast to the component side or component face 95 of submount 9). Pin 6 is electrically connected to submount 9 via solder joint 23.

According to an embodiment, in order to facilitate bonding, for example, brazing, the surface 58 of base 3 and/or mounting face 40 of pedestal 7 and/or upper surface 42 of pedestal 7 and/or the back side (or carrier side) 94 of submount 9 are Au-plated (or gold-plated) at least partially in a bonding area thereof. In case of the base, bonding area 70 is depicted in fig. 1. For the sake of visibility, bonding areas are not shown for mounting face 40, upper face 42 and the submount back side (or carrier side) 95. Further, as there is only a small gap between pedestal mounting face 40 and the surface 58 of base 3, the bonding material, such as an adhesive, or a brazing material, is drawn into the gap by capillary action. This allows for controlling the so-called submount offset (or d₂ in fig. 3) formed between submount 9 or rather, submount side face 93, and base 3 in a very tight range.

In the scope of the present invention, the upper face 42 of pedestal 7 is understood to refer to that face of the pedestal facing the pin and may therefore generally, without being restricted to the special embodiment of the header shown in fig. 5, also be denoted as "pin face" or "pin side" 42 of pedestal 7.

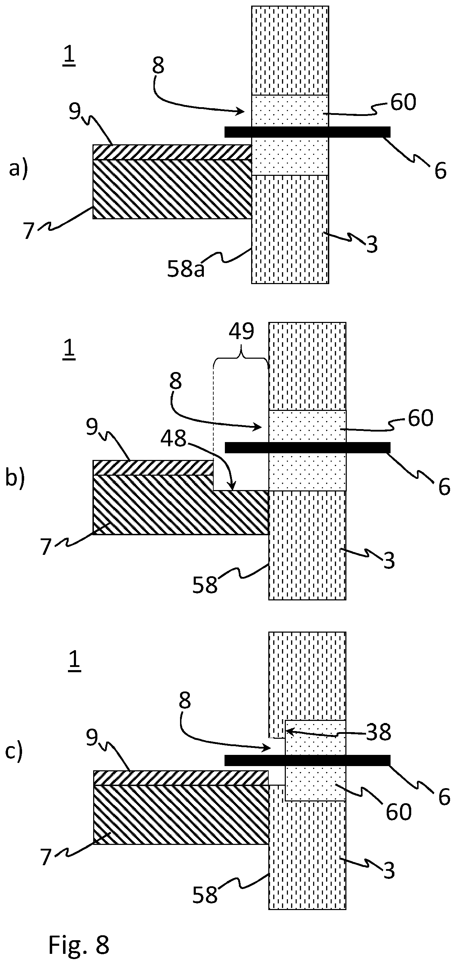

In the embodiment shown in fig. 5, pedestal submount 7 comprises an edge 50, such as a chamfer or blend edge between mounting face 40 and pin face 42, preferably enclosing an angle between edge 50 and pin face 42 and/or between edge 50 and mounting face 40 between 100° and 160°. Such an embodiment may be preferred for minimizing submount offset d₂, as in case of a chamfer or blend edge 50, a small cavity 26 is formed. In that case, the excess bonding material, such as an adhesive, or a braze or brazing material, will be able to fill in cavity 26, with the cavity acting as a "reservoir" for excess bonding material. In that case, further, only a very small to nearly zero excess bulge 25 of bonding material will be formed, which allows to control submount offset d₂. Such an embodiment may further be very advantageous as it facilitates to obtain a minimum submount offset of zero. It may be noted that generally, cavity 26 need not be filled completely with excess bonding material, in contrast to the embodiment shown in fig. 5 with completely filled cavity 26. Rather, a minimum offset d₂ may also be achieved with a partially filled reservoir only. According to a further embodiment, the pedestal may be formed in different shapes, such as comprising a pedestal step so that a gap may be formed between the surface of the header base 3 and/or the surface of sealing material 60, which is favourable if larger electronic components are to be arranged in the header. Further, the pedestal may be formed and/or fixed so that it protrudes over opening 8 at least partially. Further, according to an embodiment, alternatively or additionally the base may comprise a step (base step) 38 that protrudes over sealing material 60 at least partially. Such special shapes of pedestals 7 and/or bases 3 are also depicted in fig. 8. According to an embodiment, at least one of substance-to-substance bonds 24 and 27 comprises gold (Au) and germanium (Ge) and/or tin (Sn). Gold-tin-brazes are commonly used braze materials for TO headers, as they require only low melting temperatures. However, in case of the header according to embodiments of the present application, at least two substance-to-substance bonds, that is, at least one pedestal substance-to-substance bond 24 and at least one submount substance-to-substance bond 27 are required. As these two substance-to-substance bonds - that is, braze joints in the embodiment contemplated here - are formed at different stages in the production process, the temperature of the first brazing process should be higher than that of the second brazing process, in order to avoid de-bonding of the first joint during the second brazing. Generally, without restriction to the embodiment contemplated here with at leat two different braze joints formed in two different process steps, if the substance-to-substance bonds are formed at elevated temperature, the temperature of the first bonding process should be higher than that of the seconding bonding process. Therefore, advantageously, at least one of substance-to-substance bonds 24 and 27, that is, a pedestal braze joint and a submount braze joint as contemplated here, may comprise a gold-germanium-braze (or Au-Ge-braze).

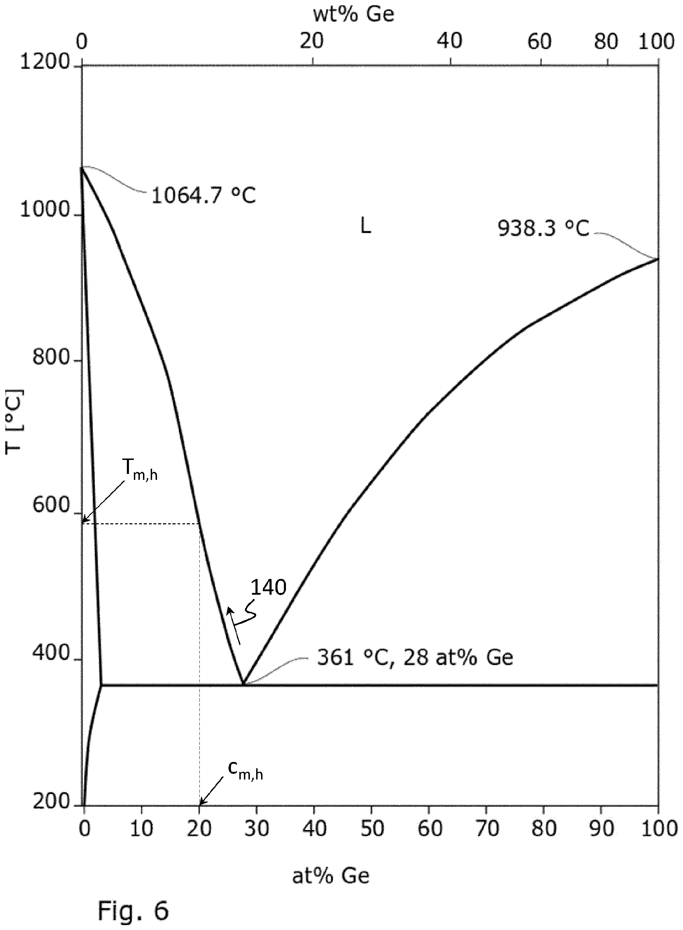

The advantage of using such a braze for at least one of substance-to-substance bonds 24, 27, formed as braze joints, will be explained with reference to the phase diagram depicted in fig. 6. Fig. 6 depicts the binary phase diagram gold-germanium, with the left side of the diagram corresponding to a germanium-content of 0, that is, to pure gold. The gold-germanium binary system is a nearly ideal eutectic system, with only a minor amount of gold-rich solid solution forming for germanium contents of less than about 4 at.-%. The eutectic composition is at a germanium content of 28 at.-% germanium, corresponding to 12 wt.-% germanium (so-called AuGe12 braze or AuGe12 solder material), with a eutectic temperature of about 361°C. As brazing with gold-tin-material is effected at temperatures of about 280°C (AuSn20 braze or solder material), AuGe12 may be used for the first brazing step and the AuSn20 for the second brazing step, as the temperature difference between these brazing materials and, thus, brazing processes is so high that the first brazing joint will not re-melt in the second brazing process.It is to be noted here that a brazing step, for example, a first brazing step, may involve the brazing of several components at the same time, that is, in case the brazing step involves brazing of pedestal 7 to base 3, all pedestals 7, 7a, 7b comprised by header 1 may be brazed in this step, thereby forming several pedestal substance-to-substance bonds 24 between pedestals 7, 7a, 7b and the surface 58 (or front face) of base 3 at the same time. The same applies for brazing of submount or submounts 9 to pedestal or pedestals 7, 7a, 7b, forming several submount substance-to-substance bonds 27. Generally, without being restricted to the example of substance-to-substance bonds 24 and 27 being braze joints, a bonding step may comprise bonding of several components at the same time.

According to an embodiment, therefore, the header comprises pedestal 7a and a further pedestal 7b, wherein pedestal 7a is connected to base 3 and comprises submount 9 connected to pedestal 7a, wherein pedestal 7a is joined to base 3 via a first pedestal substance-to-substance bond 24, and wherein pedestal 7b is connected to base 3 and comprises a further submount 9 connected to pedestal 7b, wherein the further pedestal 7b is joined to base 3 via a further pedestal substance-to-substance bond 24, wherein the pedestal substance-to-substance bond 24 between base 3 and pedestal 7a the further pedestal substance-to-substance bond 24 between base 3 and further pedestal 7b comprise the same bonding material. For example, in a particularly preferred embodiment, substance-to-substance bonds 24 and 27 may be braze joints, and pedestal substance-to-substance bonds 24 comprise the same brazing material or braze material.

However, apart from being able to use two different bonding materials, such as two different brazes, for the first and second bonding steps (e.g., brazing steps), as pointed out above, as AuGe12 is a eutectic composition, it is also possible to use AuGe12 in both brazing steps, provided that at least one of the faces to be joined comprises a gold-plating (or gold layer) at least partially in a bonding area thereof. That is because during the melting process the gold of the gold plating (or gold layer) will migrate into the melt, thereby increasing the gold content of the melt. The resulting melt composition is shifted to the gold-rich side of the phase diagram, indicated by arrow 140 in fig. 6, resulting in an increased melting temperature. An exemplary melting temperature T_{m,h} of a hypothetical exemplary gold-enriched braze-joint composition c_{m,h} has been indicated in fig.6. As can be seen for the hypothetical concentration c_{m,h} with a content of 20 wt.-% Ge, the resulting corresponding melting temperature T_{m,h} is nearly 600°C and thus much higher than the eutectic temperature of 361°C. However, it is understood here that this hypothetical composition is merely exemplary and may differ from practically obtained compositions of braze joints. As the melting temperature of the first braze joint will be higher than the eutectic temperature for the reasons pointed out above, AuGe12 brazing material might according to a particular embodiment also be used in the second brazing step.

While the binary system AuSn is more complex than the AuGe system as shown in fig. 6, this principle of increasing the melting temperature by increasing the gold content of the melt applies to AuSn braze material as well, thereby enabling the use of AuSn-solders (or brazes) in both bonding steps in case at least one of the faces of the components or parts to be joined is gold-plated or comprises a gold plating or a gold layer at least partially in a bonding area thereof.

Therefore, according to an embodiment substance-to-substance bonds 24 and 27 may both be braze joints and comprise Au and Ge and/or Sn. For the reasons pointed out above, however, the composition of substance-to-substance bonds 24 and 27 formed as braze joints may be different, the first braze joint (or set of braze joints) formed probably having a higher gold content than the second braze joint (or set of braze joints) formed. Here, the term "the first substance-to-substance bond (or the first set of substance-to-substance bonds)" is understood to refer to the substance-to-substance bond of substance-to-substance bonds formed during a first bonding process, whereas "the second substance-to-substance bond (or the second set of sub stance-to-substance bonds)" is understood to refer to the substance-to-substance bond or joints formed during a second bonding step that takes place after the first bonding. As will be explained in detail below, both substance-to-substance bond 24 and 27 may be a "first" or "second" substance-to-substance bond in this respect. If substance-to-substance bonds 24 and/or 27 are braze joints, this applies mutatis mutandis to first braze joints (or first set of braze joints) and second braze joints (or second set of braze joints).

Faces to be joined that could preferably be gold-plated or comprise a gold-plating or a gold layer at least partially in a bonding area thereof are the surface 58 of base 3 and mounting face 40 for substance-to-substance bond 24 (pedestal substance-to-substance bond 24) and upper face 42 and carrier face 94 of submount 9 for substance-to-substance bond 27 (submount substance-to-substance bond 27). However, it may be sufficient that only one of the faces to be joint may be gold-plated. For example, regarding substance-to-substance bond 27, in case upper face 42 is gold-plated at least in a bonding area thereof at least partially, the carrier face 94 of submount 9 does not need to be gold-plated at all and vice versa. The same applies to substance-to-substance bond 24 (pedestal substance-to-substance bond), of course.

The present application further relates to a method for manufacturing a header, especially a header according to embodiments of the present disclosure.

The method for producing header 1 for an electronic component, preferably a TO header 1, particularly preferably a header 1 according to embodiments of the disclosure, comprises the following steps:
- forming a base 3 comprising openings 8, wherein the base 3 does not comprise pedestals 7, 7a, 7b for accommodating a submount 9. That is, base 3 may be understood as a "blank base". Such a blank base, that is, a base that does not comprise any pedestals formed integrally with the base, may be formed in a standard, low-cost, stamping process. Further, such a stamping of a blank base is less complex that stamping a "standard base" comprising at least one integrally formed pedestal.
- forming a feedthrough 5 by introducing a pin 6 into at least one opening 8 and sealing the opening 8 with an insulating material 60 so that the pin 6 is fixed within opening 8 and electrically insulated from the base 3. Any suitable insulating material 60 may be used, for fixing pin 6 within opening 8 and electrically insulating it from base 3, however, it may be preferred to use glass as insulating material 60, so that feedthrough 5 is formed as a glass-to-metal-seal. Such glass-to-metal-seals (GTMS) are known products and may be manufactured according to customers' needs, for example, using particularly preferred materials both for the base 3 and pin 6 and adjusting desired temperature stabilities of the feedthrough and, thus, the header.
- optionally applying a thin gold layer at least in a bonding area 70 of the base 3 at least partially. Application of a thin gold layer - or gold plating - is a quite known process in electronic packaging, for example, in order to prevent oxidation of a base metal such as nickel. Gold plating a bonding area 70 of base 3 at least partially may be preferred especially if a brazing material containing gold, especially AuGe12, AuSn20 brazing material, is used for forming a pedestal substance-to-substance bond 24 (or pedestal braze joint in this case). In that case, as has been explained in detail above with respect to the phase diagram depicted in fig. 6, because of fusing the gold layer at least partially, with gold migrating into the eutectic melt, resulting in a melting temperature elevation and thereby thermally stabilizing the resulting substance-to-substance bond. However, it may be contemplated to gold-plate mounting face 42 of pedestal 7, 7a, 7b at least partially instead, as in general, only one of the faces of the components to be joined with AuGe12 or AuSn20 brazing material should preferably be gold-plated at least partially for melting temperature elevation to take place. In that respect, if forming pedestal substance-to-substance bond 24 with another brazing material that does not comprise gold, the gold-plating may be dispensed with.
- forming a pedestal 7, 7a, 7b. That is, the pedestal is formed in a separate process. Therefore, not only stamping may be used to form the pedestal, but further production processes such as metal extrusion or metal drawing may be employed. Thus, pedestal 7, 7a, 7b may be formed in a complex form, for example, with at least one edge 50 formed as a rounded edge or a chamfer edge, as depicted above in fig. 5. Further, pedestal 7, 7a, 7b may comprise further features facilitating mounting processes of submount or submounts 9.
   These further features of the pedestal will now be explained with reference to a pedestal 7. It is understood here, however, that when reference is made to the shape of a pedestal 7, this applies to pedestals 7a, 7b and, in general, further pedestals comprised by the header.
   Generally, without being restricted to the embodiments depicted in the figures of the application, at least one pedestal 7 has a cuboid or prismatic shape with at least one plane side face 42 for accommodating a submount. This at least one plane side face will, upon assembly, face a pin 6 and is therefore referred to as pin face 42. Further, pedestal 7 comprises an at least partially plane base face 40 for forming a joint to base 3. That at least partially plane base face 40 will be referred to as mounting face 40 of pedestal 7. Opposite to mounting face 40 and preferably parallel to if, pedestal 7 comprises a further face, that may also be referred to as the pedestal free face. Generally, pedestals 7, 7a, 7b of header 1 may be of equal or at least corresponding shape, or may be formed mirror symmetrically. According to a preferred embodiment, pedestals 7, 7a, 7b may be arranged symmetrically on base 3 with respect to an imaginary plane parallel to a height and width direction of the pedestals. That is, the pedestal is understood to have a first, longitudinal direction, this direction being a first direction of a Cartesian coordinate system, running parallel to the longest outer dimension of the pedestal and being perpendicular to the surface 58 of base 3. Further, pedestal 7 has a second or width direction, this direction being a second direction of a Cartesian coordinate system at a right angle to the longitudinal direction and running parallel to pin face 42. Further, the height direction is at right angles to both the longitudinal and width directions. Pedestal 7 may according to a further embodiment comprise at least one bar arranged on pin face 42, preferably forming a side wall. This may be preferred as in that case, the bar may facilitate alignment of submount 9 in pin face 42. Such a pedestal comprising at least one bar may also be called L-shaped, especially if the bar extends over the whole length of pin face 42. Further, pedestal 7 may according to a further embodiment comprise a further bar, leading to a U-shaped pedestal. In case the bar or bars are shorter than the pin face length, this may lead to a partially L-shaped profile or a partially U-shaped profile, respectively. Bar or bars and pedestal 7 may preferably comprise the same material and are particularly preferably formed integrally in one piece. As pointed out above, pedestals 7, 7a, 7b may be of equal or corresponding shape, however, it may also be possible that their shape differs.
- providing a submount 9. Pedestals 7, 7a and 7b, preferably pedestals 7, 7a, 7b according to embodiments as explained in detail above, may be combined with any submount 9, however, it has been found that particularly in case of pedestals according to embodiments, may be preferably combined with submounts 9 that are equally formed but mounted in different orientations. "Equally formed submounts" are understood here to refer to submounts with metal patterns that correspond to each other, in order to facilitate assembly. However, they are mounted in different orientations, in order to enable connecting the electronic device (placed in gap 12 in between pedestals 7a, 7b, for example) from opposite directions. According to an embodiment, the submounts 9 are mounted onto the at least one pedestal 7, 7a, 7b so that the respective ends of conductor traces on the component side 95 of the submounts 9 that are connected to the feedthrough pins 6 face each other. The conductor traces connected to the feedthrough pins 6 are typically the signal carrying conductors. Thus, using a configuration where the ends distal to the feedthrough pins 6 face each other, the distances for the connection to the electronic device can be reduced.
   In a preferred embodiment, the pattern of the structured conductor plating of the submount 9 has a mirror symmetry. This enables to use submounts 9 mounted with different ends pointing towards the base 3 and therewith have the ends of the conductor traces facing each other. Thus, according to a preferred embodiment, the submounts 9 have two opposite ends and are mounted with one end facing the base 3 and wherein a symmetry plane of the mirror symmetrical conductor plating is located between the ends. In particular, the submounts 9 may have two opposite ends, in particular ends that are distinguishable with respect to each other, wherein one of the submounts 9 is attached to the pedestal 7, 7a, or 7b with one end facing the base and the other submount 9 is attached to the pedestal 7, 7a, 7b with the opposite end facing the base 3. This way, the "left" and "right" submounts 9 (with respect to gap 12 or the electronic component placed in between submounts 9) are of the same type but are simply mounted with one of the submounts 9 turned around by 180°.
- optionally applying a thin gold layer at least in a bonding area of the pedestal 7, 7a, 7b and/or of a carrier face 94 of the submount 9 at least partially. As pointed out above with respect to an optional gold-plating of bonding area 70 at least partially, such a process may be preferred in case a AuGe and/or AuSn braze joint is to be formed between pedestal or pedestals 7, 7a, 7b and base 3 and/or a submount or submounts 9.
- bonding of the pedestal or pedestals 7, 7a, 7b to the base 3, thereby forming a pedestal substance-to-substance bond 24, for example, by brazing. By bonding, e.g. brazing, pedestal 7 - or pedestals 7, 7a, 7b in case base 3 and/or header 1 comprises a plurality of pedestals - may be fixedly attached to base 3. That is, while separating the manufacture of the blank base and pedestal or pedestals 7, 7a, 7b, thereby enabling the formation and/or use of complex-shaped pedestals that may be employed to facilitate the assembly of the header or to enable an improved overall performance of the header, still a strong connection will be formed between the pedestal or pedestals and the base.
- bonding of the submount 9 (or submounts 9) to the pedestal 7, 7a, 7b (or several pedestals 7, 7a, 7b), thereby forming a submount substance-to-substance bond 27 (or several submount substance-to-substance bonds 27), for example, by brazing, thereby forming a braze joint or braze joints.
- optionally abrading the surface of base 3 and/or the sealing material 60 so that preferably a resulting surface 58a of base 3 and the sealing material 60 are on the same level, that is, in-plane.

According to a further embodiment, a plurality of pedestals 7, 7a, 7b is bonded or joined or connected to base 3, thereby forming a plurality of pedestal substance-to-substance bonds 24. Preferably, in that case, all pedestal substance-to-substance bonds 24 comprise the same bonding material. For example, of the substance-to-substance bonds are formed by brazing, all pedestal braze joints may comprise the same brazing material or braze material. Such a process wherein at least two pedestals are bonded, for example, brazed, to the base may be preferred for headers 1 comprising DML that need two RF signal lines. Further, it may be preferred to use the same bonding material, such as a braze, for forming the same or corresponding substance-to-substance bonds, that is, substance-to-substance bonds between the same or at least corresponding components, such as between several pedestals and the base. In this way, the substance-to-substance bonds may be formed in the same bonding step in a cost-efficient, simple way, for example, by brazing.

Likewise, according to a further embodiment, to each pedestal 7, 7a, 7b a respective or corresponding submount 9 is bonded, thereby forming a plurality of submount substance-to-substance bonds 27. Preferably, in that case, all submount substance-to-substance bonds 27 comprise the same bonding material. Here, too, all substance-to-substance bonds 27 may in that way be formed in a single step at the same time. According to e preferred embodiment, bonding may be achieved by brazing, wherein all braze joints (submounts braze joints in that case) comprise the same brazing material or braze material.

According to an embodiment, the submount or submounts 9 are bonded to the pedestal or pedestals 7, 7a, 7b prior to bonding the pedestal or pedestals 7, 7a, 7b to base 3, for example, in a brazing process. Such a process may be preferred if a minimum pin offset (d₁ in fig 2) is to be achieved, as in that case submount 9 (bonded, e.g., brazed, to a pedestal 7) may be positioned very close to pin 6. It may even be contemplated to arrange the assembly comprising submount 9 and pedestal 7 (or 7a, 7b, for that matter) on base 3 so that component side 95 of submount 9 even touches pin 6.

Preferably, in that case, submount substance-to-substance bond or submount substance-to-substance bonds 27 are formed as braze joint or braze joints and comprise gold and germanium, and the pedestal substance-to-substance bond or pedestal substance-to-substance bonds 24 are formed as braze joint or braze joints and comprise gold and germanium and/or tin. In that way, it may be ensured that the submount braze joint or joints - that according to the embodiment contemplated here are formed prior to pedestal braze joint or pedestal braze joints - will not re-melt during the second brazing process.

However, according to a further embodiment, it is also possible to bond the pedestal or pedestals 7, 7a, 7b to base 3 prior to bonding the submount or submounts 9 to the pedestal or pedestals 7, 7a, 7b. Likewise, in that case, bonding may in a quick and easy manner be achieved by brazing. Such a process resembles the state-of-the-art processes in electronic packaging employing bases with integrally, in-one-piece formed pedestals, and might therefore be preferred as known submount joining processes and facilities may be employed. However, in that case, also known problems with respect to pin offset and, therefore, poor RF signal performance of the electronic component may result.

Preferably, if pedestal substance-to-substance bond or joints 24, formed as pedestal braze joint or joints in a brazing process, are formed prior to forming submount substance-to-substance bond or joints 27, formed as submount braze joint or joints, the pedestal braze joint or pedestal braze joints comprise gold and germanium, and the submount braze joint or submount braze joints comprise gold and germanium and/or tin. As has been explained in detail above, in general, the first-to-be formed substance-to-substance bond (or set of substance-to-substance bonds) should comprise the bonding material with higher melting point, in order to avoid re-melting of this substance-to-substance bond (or set of substance-to-substance bonds) during subsequent brazing procedures. As a result, in the embodiment contemplated here, as substance-to-substance bond or joints 24 are formed prior to substance-to-substance bond or joints 27, pedestal substance-to-substance bond or joints 24 preferably comprise gold and germanium and may, for example, be formed with AuGe12 as brazing material, and submount substance-to-substance bond or joints 27 may comprise gold and germanium and/or gold. However, it is also possible to use AuSn20 or AuGe12 in both brazing steps. However, because of the larger difference in melting temperatures when using different braze materials (such as AuGe12 in a first brazing steps and AuSn20 in a second brazing step) or when using AuGe12 due to the very pronounced eutectic in the AuGe binary phase diagram, using AuSn20 in both brazing steps may not be preferred.

Further, generally, without being restricted to the embodiment of the manufacturing process discussed in the last paragraph, in case both substance-to-substance bond or bonds 24 and substance-to-substance bond or bonds 27 are formed as braze joints with AuGe12 as brazing material, it may be contemplated to gold-plate at least one of the face to be joined at least in a bonding area thereof at least partially, which will result in the first-to-be formed substance-to-substance bond (or bonds) to have a higher melting temperature than the eutectic temperature of the AuGe12 eutectic composition due to melting the gold-plating at least partially, thereby rising the melting temperature of the resulting metal melt.

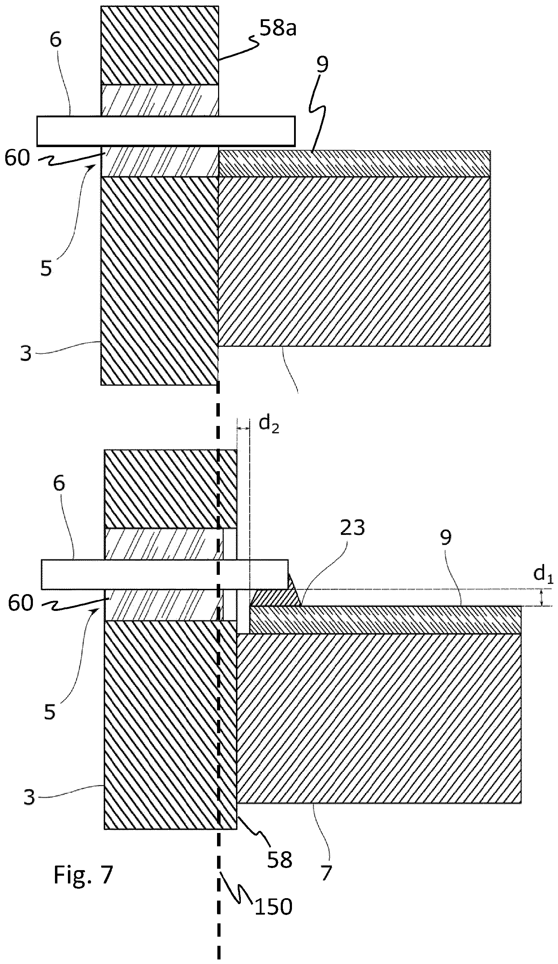

Fig. 7 depicts a further sectional partial view of two headers 1 according to embodiments. Here, the lower part of fig. 7 shows a partial sectional view of a header 1 according to the sectional partial view of fig. 2. Further, the surface 58 of base 3 has been indicated, as well as ground or grinding level 150. In order to achieve a very good to optimal control of the header impedance, it may according to an embodiment be contemplated to grind the surface of the sealing material, for example, a glassy sealing material in further processing. This is possible because according to the present disclosure, header base 3 is provided as a blank base, that is, without any pedestals 7. If grinding takes place, base material and sealing material 60 may both be removed, preferably in the same process, which results in the surface of the sealing material and the resulting base surface 58a (that is, the surface of base 3 after material removal) being in-plane. Resulting surface 58a has been indicated in the upper part of fig. 7, showing a partial sectional view of header 1, obtained by grinding of the header shown in the lower part of fig. 7, with grinding level 150. It is noted here that the resulting surface 58a corresponds to the grinding level 150 and that sealing material surface and surface 58a are in-plane. Sealing material surface and surface 58a being in-plane is favourable, as in this way, a very good control of the impedance of the resulting header and hence a more reliable performance may be achieved.

Fig. 8 shows further partial sectional views of headers 1 according to further embodiments, illustrating the technical advantages of forming pedestal or pedestals 7, 7a, 7b and header base 3 in separate manufacturing processes. That is, if base 3 and pedestal or pedestals 7, 7a, 7b are obtained in separate manufacture processes, the pedestal or pedestals 7, 7a, 7b may be shaped in various types, offering several advantages. It is possible that in case of more than one pedestal, all pedestals comprised by header 1 have the same shape; however, it is also possible that header 1 comprises pedestals 7, 7a, 7b with different shapes. With respect to the header 1 depicted in fig. 8 a), pedestal 7 is shaped to protrude over opening 8 filled with sealing material 60. This may be favourable if a thin submount 9 or thin submounts 9 are to be employed. Further, pedestal 7 protruding over opening 8 at least partially may be preferably be combined with a grinding of sealing material 60 and base 3. Therefore, in the upper part of fig. 8, the surface of base 3 has been indicated to be a resulting surface 58a, that is, obtained after a material abrasion process such as grinding and/or polishing. However, generally, without being restricted to header 1 as shown partially in the upper part of fig. 8, special shapes of pedestals 7, such as pedestals 7 protruding over opening 8, may be combined with headers 1 with original header base surfaces 58.

In fig. 8 b), pedestal 7 is shaped in a way that step 48 is formed (pedestal step 48), which results in an L-shape of pedestal 7 in sectional view, as depicted here. Pedestal 7 is formed to protrude over opening 8 of base 3, however, due to step 48, gap 49 is formed between the header base surface 58 (or 58a, in case the surface of the header has been obtained in a material-removing process such as grinding or polishing) and/or the surface of the sealing material. Gap 49 may serve to accommodate further components, or provides more space for large components, such as monitor photodiodes (MPD).

In fig. 8 c), a yet further embodiment of header 1 is depicted in a partial sectional view. Here, opening 8 of base 3 is shaped in a way that step 38 (or base step) is obtained, the base material, in that case, overlapping sealing material 60 at least partially. Such a shape of header base 3 can be used as circuit compensation. In particular, this compensation may be a C-L-C-sequence, i.e. a sequence of a capacitive element, an inductive element and a further capacitive element. It is understood here that step 38 is built as a circumferential step with respect to opening 8.- The present application further relates to a header 1, preferably a header 1 according to any of the embodiments of the disclosure, that is produced in or producible in a method according to any of the embodiments of the present disclosure.

**Reference numerals**

| | |
|---|---|
| 1 | header |
| 3 | base |
| 5 | electrical feedthrough |
| 6 | feedthrough pin |
| 7 | pedestal |
| 7a | first pedestal |
| 7b | second pedestal |
| 8 | opening |
| 9 | submount |
| 12 | gap |
| 23 | solder joint |
| 24 | substance-to-substance bond, pedestal bond (or joint) |
| 25 | bonding bulge |
| 26 | cavity, bonding reservoir |
| 27 | further substance-to-substance bond, submount bond (or joint) |
| 38 | step, base step |
| 40 | mounting face |
| 42 | upper surface, pin face |
| 48 | step, pedestal step |
| 49 | gap |
| 50 | edge |
| 58 | Base front face of base 3, surface of base 3 |
| 60 | insulating material |
| 93 | side edge of submount 9 |
| 94 | carrier face of submount 9 |
| 95 | component face of submount 9 |
| 140 | arrow |
| 150 | ground level, grinding level |
| d1 | pin offset |
| d2 | submount offset |
| T_{m,h} | melting temperature of hypothetical melt |
| C_{m,h} | concentration of hypothetical melt |

## Claims

1. A header (1) for an electronic component, comprising a base (3) with at least one feedthrough (5), the feedthrough (5) comprising a feedthrough pin (6) extending through the base (3) and being electrically insulated from the base (3), and at least one pedestal (7, 7a) connected to the base (3) and comprising a submount (9) connected to the pedestal (7), wherein the pedestal (7, 7a, 7b) is joined to the base (3) via a pedestal substance-to-substance bond (24), preferably via a pedestal braze joint.

2. The header (1) according to claim 1, wherein the submount (9) is joined to the pedestal (7, 7a) via a submount substance-to-substance bond (27), preferably via a submount braze joint.

3. The header (1) according to any of claims 1 or 2, with a submount offset (d₂) formed between the submount (9) and the surface of the base (3) of at most 0.1 mm and/or with a pin offset (di) formed between the pin (6) and the surface of the submount (9) of at most 0.2 mm and preferably of at least 0.05 mm.

4. The header (1) according to any of claims 1 to 3, wherein the surface of the base (3) and/or the mounting face (40) of the pedestal (7) and/or the pin surface (42) of the pedestal (7, 7a) and/or the carrier face (94) of the submount (9) are Au-plated at least partially in a bonding area (70) thereof.

5. The header (1) according to any of claims 1 to 4, wherein at least one substance-to-substance bond (24, 27) comprises Au and Ge and/or Sn.

6. The header (1) according to any of claims 1 to 5, wherein the pedestal (7, 7a, 7b) comprises an edge (50), such as a chamfer or blend edge, thereby forming a cavity (26) and/or wherein the pedestal (7, 7a, 7b) comprises a pedestal step (48) so that preferably a gap (49 is formed and/or wherein the pedestal (7, 7a, 7b) protrudes over the opening (8) at least partially and/or wherein the base (3) comprises a base step (38).

7. The header (1) according to any of claims 1 to 6, comprising a further pedestal (7b) connected to the base (3) and comprising a submount (9) connected to the further pedestal (7b), wherein the further pedestal (7b) is joined to the base via further pedestal substance-to-substance bond (24), wherein the further pedestal substance-to-substance bond (24) between the pedestal (7, 7a) and the further pedestal (7b) comprises the same bonding material.

8. A method for producing a header (1) for an electronic component, preferably a TO header (1), particularly preferably a header (1) according to any of claims 1 to 7, comprising the following steps:
- forming a base (3) comprising openings (8), wherein the base (3) does not comprise pedestals (7, 7a, 7b) for accommodating a submount (9),
- forming a feedthrough (5) by introducing a pin (6) into at least one opening (8) and sealing the opening (8) with an insulating material (60) so that the pin (6) is fixed within the opening (8) and is electrically insulated from the base (3),
- optionally applying a thin gold layer at least in a bonding area (70) of the base (3) at least partially,
- forming a pedestal (7, 7a, 7b),
- providing a submount (9)
- optionally applying a thin gold layer at least in a bonding area of the pedestal (7, 7a, 7b) and/or of a carrier face (94) of the submount (9) at least partially,
- bonding, preferably brazing, of the pedestal (7, 7a, 7b) to the base (3), thereby forming a pedestal substance-to-substance bond (24),
- bonding, preferably brazing, of the submount (9) to the pedestal (7, 7a, 7b), thereby forming a submount substance-to-substance bond (27),
- optionally abrading the surface of the base (3) and/or the sealing material (60) so that preferably a resulting surface (58a) of the base (3) and the sealing material (60) are on the same level.

9. The method according to claim 8, wherein a plurality of pedestals (7, 7a, 7b) is brazed to the base (3), thereby forming a plurality of pedestal substance-to-substance bonds (24), wherein preferably all pedestal substance-to-substance bonds (24) comprise the same bonding material.

10. The method according to claim 9, wherein to each pedestal (7, 7a, 7b) a respective submount (9) is bonded, thereby forming a plurality of submount substance-to-substance bonds (27), wherein preferably all submount substance-to-substance bonds (27) comprise the same bonding material.

11. The method according to any of claims 8 to 10, wherein the submount or submounts (9) are bonded to the pedestal or pedestals (7, 7a, 7b) prior to bonding the pedestal or pedestals (7, 7a, 7b) to the base (3).

12. The method according to claim 11, wherein the submount substance-to-substance bond or submount substance-to-substance bonds (27) comprise gold and germanium, and wherein the pedestal substance-to-substance bond or pedestal substance-to-substance bonds (24) comprise gold and germanium and/or tin.

13. The method according to any of claims 8 to 10, wherein the pedestal or pedestals (7, 7a, 7b) are bonded to the base (3) prior to bonding the submount or submounts (9) to the pedestal or pedestals (7, 7a, 7b).

14. The method according to claim 13, wherein the pedestal substance-to-substance bond or pedestal substance-to-substance bonds (24) comprise gold and germanium, and wherein the submount substance-to-substance bond or submount substance-to-substance bonds (27) comprise gold and germanium and/or tin.

15. A header (1), preferably a header (1) according to any of claim 1 to 7, produced or producible in a method according to any of claims 8 to 14.
